# FASCICULE DE BREVET EUROPEEN

(11) **EP 0 780 890 B1**
(45) Date de publication et mention de la délivrance du brevet: **28.08.2002**
(21) Numéro de dépôt: 96402751.0
(22) Date de dépôt: 16.12.1996
(51) Int. Cl.: H01L 21/288, H05K 3/24, C25D 5/02

(54) **Procédé de dépot électrochimique**
Elektrochemisches Abscheideverfahren
Method of electrochemical deposition

(30) Priorité: 18.12.1995 FR 9514972
(43) Date de publication de la demande: 25.06.1997
(73) Titulaire: COMMISSARIAT A L'ENERGIE ATOMIQUE, 75015 Paris Cédex 15 (FR)
(72) Inventeur: Caillat, Patrice, 38130 Echirolles (FR); Massit, Claude, 38330 Saint-Ismier (FR)
(74) Mandataire: Dubois-Chabert, Guy

(56) Documents cités:
- DE-A- 4 131 731
- GB-A- 1 127 070
- US-A- 4 202 001
- PATENT ABSTRACTS OF JAPAN vol. 18, no. 33 (E-1493), 18 Janvier 1994 & JP 05 267306 A (TOSHIBA CORP.), 15 Octobre 1993,
- SENSORS AND ACTUATORS A, vol. 43, 1994, LAUSANNE CH, pages 296-301, XP000567518 R. KAKEROW ET AL.: "A monolithic sensor array of individually addressable microelectrodes"
- PATENT ABSTRACTS OF JAPAN vol. 18, no. 175 (P-1716), 24 Mars 1994 & JP 05 340915 A (MATSUSHITA ELECTRIC IND CO), 24 Décembre 1993,
- PATENT ABSTRACTS OF JAPAN vol. 15, no. 442 (E-1131), 11 Novembre 1991 & JP 03 185897 A (MATSUSHITA ELECTRIC IND CO), 13 Août 1991,
- PATENT ABSTRACTS OF JAPAN vol. 18, no. 627 (P-1834), 29 Novembre 1994 & JP 06 242052 A (MITSUBISHI ELECTRIC CORP), 2 Septembre 1994,

## Description

### Domaine technique

La présente invention se rapporte à un procédé de dépôt électrochimique et en particulier pour dépôt électrolytique.

On utilise comme support, un substrat intégrant ou non des fonctions logiques et/ou mécaniques et/ou chimiques et/ou optiques. Un support peut par exemple être une puce ou un ensemble de puces microélectroniques comportant des électrodes, c'est-à-dire des sites aptes à recevoir un dépôt électrochimique.

L'invention trouve notamment des applications dans le domaine de la microélectronique pour déposer sur des électrodes des matériaux conducteurs électriques, en des endroits déterminés. L'invention peut servir par exemple à réaliser un support avec des billes d'interconnexion disposées sur des plots de contact d'une puce.

L'invention trouve également des applications dans la fabrication de systèmes d'analyse en biologie, dans lesquels des polymères doivent être déposés également en des endroits déterminés sur des électrodes.

### Etat de la technique antérieure

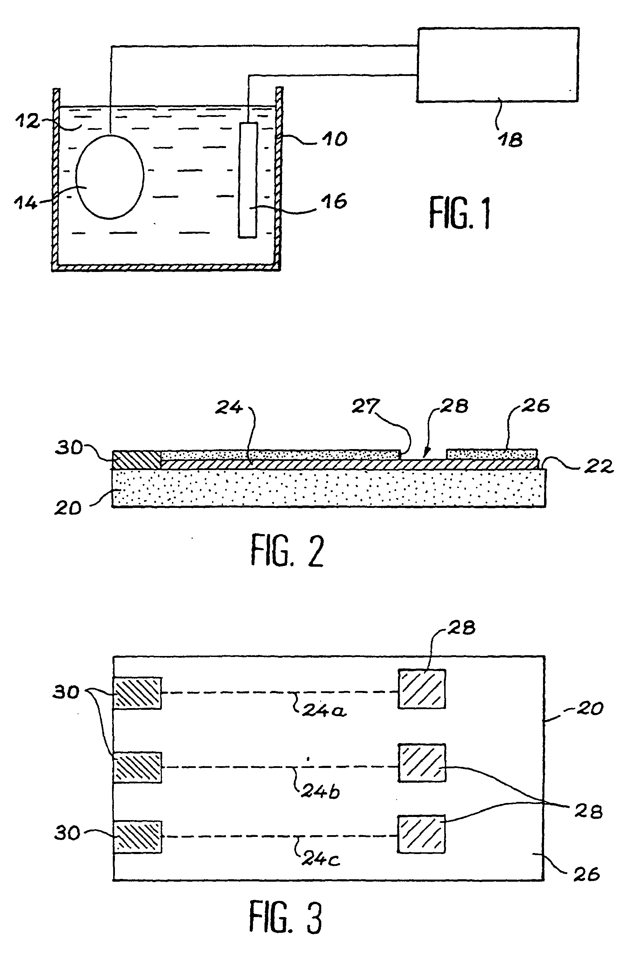

La figure 1 permet de rappeler brièvement les éléments d'un équipement pour effectuer un dépôt électrochimique sur un support.

Dans une cuve 10 emplie d'un électrolyte 12 est plongée une pièce à traiter formant électrode ou un support avec une surface conductrice formant électrode. Cette pièce est repérée par la référence 14. Une contre-électrode 16 est également plongée dans l'électrolyte. L'électrode 14 et la contre-électrode 16 sont respectivement reliés électriquement aux bornes d'un générateur de tension 18.

L'électrolyte 12 comporte généralement des ions métalliques en solution qui, en fonction de leur charge et de la tension appliquée par le générateur 18, se déposent sur l'électrode 14.

Cette technique de base est de plus en plus utilisée. Initialement réservée au dépôt de métaux purs tels que le cuivre ou le nickel, par exemple, elle se généralise à l'heure actuelle aux dépôts électrochimiques faisant appel non plus à un déplacement d'ions simples mais à des composés complexes organiques conducteurs. A titre d'exemple, on peut mettre à profit une réaction d'oxydoréduction qui s'opère sur la pièce à traiter, ou l'électrode, pour copolymériser des polymères entre eux.

Dans la suite de l'exposé, l'électrolyte sera ainsi défini comme une solution comportant des ions en solution et/ou des polymères.

Comme décrit précédemment, les techniques d'électrochimie sont bien connues et remarquablement utilisées notamment en microélectronique. Dans le domaine de la microélectronique, le dépôt électrochimique est généralement utilisé non pas pour recouvrir l'ensemble de la surface d'une puce mais des parties parfaitement définies de celle-ci. On a décrit par exemple une méthode utilisée pour déposer à la surface d'une puce un matériau conducteur, en l'occurrence un alliage d'étain et de plomb.

La méthode correspondant à la figure 2 comprend les opérations suivantes.

Sur une plaquette 20 qui peut comporter par exemple une puce électronique, est déposée une fine couche conductrice 24 sur toute sa surface. Une couche de résine 27 est ensuite déposée puis insolée à travers un masque de façon à ce qu'après développement, les sites où le dépôt doit être réalisé, restent sans résine. Un contact 30 est pris sur la plaquette par la fine couche conductrice. La plaquette est ensuite trempée dans une électrolyte ; le contact 30 est relié à une borne du générateur, l'autre borne du générateur étant reliée à une contre-électrode 16 qui est également trempée dans l'électrolyte 12. Le dépôt électrochimique se fait alors dans les ouvertures ménagées dans la résine. La plaquette est ensuite rincée puis la résine est enlevée. Il reste alors à effectuer une étape de gravure chimique qui permet d'enlever la fine couche conductrice. On obtient ainsi un dépôt localisé par électrochimie.

Cette méthode est bien adaptée au dépôt d'un même composé sur l'ensemble des sites.

Une deuxième méthode peut être utilisée comme décrit dans le document (1) et illustrée par la figure 3. Pour éviter d'avoir à déposer sur toute la plaquette une couche métallique et d'utiliser une résine ainsi qu'une gravure chimique, on relie par des pistes électriques discrètes 24a, 24b, 24c, les sites 28a, 28b, 28c où doivent avoir lieu les dépôts, à des bornes électriques qui seront reliées ensuite au générateur de tension.

Cette méthode permet de déposer, sélectivement, site après site un composé puisque l'on peut adresser par les bornes un site et un seul à la fois. Ensuite, il suffit de changer d'électrolyte, d'adresser via la borne 30b un autre site 28b et on déposera un autre matériau, etc..

Dans les deux méthodes décrites précédemment, la structure de la cellule électrochimique (ou cuve) reste la même avec une contre-électrode indépendante de la plaquette située dans la cellule.

Le document (2), référencé à la fin de la présente description, montre une puce multiplexée avec des électrodes. La puce comporte un circuit logique interne permettant d'adresser une à une les électrodes à partir de moyens de connexion externes en nombre limité.

Les documents (3), (4), (5), (6) dont les références sont précisées à la fin de la description, donnent une illustration complémentaire de l'état de la technique. 3

Le document (3) montre un dispositif de formation de bossages conducteurs par voie électrochimique sur les électrodes d'un substrat.

Le document (4) décrit un capteur chimique comprenant sur un même substrat un jeu de microélectrodes entourées par une contre-électrode.

Le document (5) décrit un procédé de fabrication collective d'une pluralité de composants à semi-conducteur ayant chacun au moins un contact plaqué.

Le document (6) montre un dispositif pour le plaquage électrochimique sélectif d'électrodes existant à la surface d'un substrat.

Dans la plupart des dispositifs connus, décrits ci-dessus, le volume total de la cuve contenant l'électrolyte est relativement important. En effet, le volume doit être suffisant pour pouvoir contenir à la fois la pièce à traiter, par exemple une plaquette, et la contre-électrode. Ceci apparaît comme une contrainte importante si l'électrolyte utilisé est très coûteux.

Par ailleurs, lorsque l'électrolyte présente une forte résistivité des problèmes d'homogénéité du dépôt peuvent apparaître. Ces problèmes sont d'autant plus important que la distance entre le site de dépôt, c'est-à-dire l'électrode, et la contre-électrode est grande.

Pour apporter une solution à ces difficultés, un but de la présente invention est de proposer un dépôt électrochimique adapté de façon à réduire dans de fortes proportions le volume d'électrolyte nécessaire au dépôt.

Un autre but est de proposer un dépôt électrolytique autorisant un dépôt homogène quasi-indépendamment de la résistivité de l'électrolyte.

### Exposé de l'invention

Pour atteindre ces buts, l'invention est définie par les caractéristiques de la revendication 1.

Le substrat peut être aussi bien passif qu'actif. Il peut intégrer en particulier des fonctions logiques et/ou chimiques et/ou mécaniques et/ou optiques. Le substrat doit être cependant passif vis-à-vis du bain chimique.

Grâce à ces caractéristiques, comme le support intègre la contre-électrode, un gain de volume important peut être obtenu pour la cuve de bain électrolytique.

De plus, les secondes surfaces conductrices étant formées sur le même substrat que les premières surfaces conductrices, la distance électrode-contre-électrode peut être réduite.

Selon une réalisation particulière du support, le substrat peut comporter une bande de matériau conducteur entourant au moins une partie de ladite pluralité de premières surfaces conductrices et formant la deuxième surface conductrice.

Selon une autre réalisation, le substrat peut comporter une grille de matériau conducteur formant la deuxième surface conductrice, la grille présentant une pluralité de mailles et chaque maille entourant au moins une desdites premières surfaces conductrices.

Selon un autre mode de réalisation, le substrat peut comporter une pluralité de bandes de matériau conducteur disposées entre les premières surfaces conductrices et reliées entre elles ; ces bandes formant la deuxième surface conductrice.

Selon l'agencement de la (des) bande(s) de matériau conducteur ou de la grille formant contre-électrode il est possible d'adapter pour chaque électrode la distance qui la sépare de la contre-électrode. Cette mesure contribue à une amélioration de l'homogénéité du dépôt électrolytique.

Les premières surfaces conductrices et les deuxièmes surfaces conductrices peuvent être réalisées en un matériau choisi par exemple parmi Al, Au, Pt, Ag, Ni,...etc.

Le support peut comporter une pluralité de puces de microélectronique, chaque puce étant pourvue d'au moins une desdites première surface conductrices. On entend par puce un regroupement d'électrodes sur un substrat passif ou actif.

Ainsi de façon avantageuse, on peut traiter simultanément plusieurs puces identiques ou différentes en recouvrant par dépôt électrochimique leur surfaces conductrices formant électrode.

En ayant recours à plusieurs bains d'électrolyte, il est aussi possible de réaliser des dépôts de matériaux différents pour différentes surfaces conductrices de chaque puce.

Après le traitement collectif des puces, celles-ci peuvent être éventuellement séparées par sciage du support.

Les moyens de connexion prévus pour relier les surfaces conductrices à la source de tension peuvent comporter des premières bornes d'adressage disposées respectivement sur chaque puce, des deuxièmes bornes d'adressage, dites bornes collectives, disposées sur le substrat et au moins un réseau d'interconnexion reliant les premières bornes et les deuxièmes bornes, selon un plan de connexion prédéterminé.

Ainsi, un signal d'adressage ou une tension de polarisation appliquée sur l'une des bornes collectives peut être distribué à l'ensemble des puces du support, pour le traitement collectif d'électrodes déterminées des puces.

Le plan de connexion peut être choisi de préférence de façon à relier les premières bornes d'adressage en parallèle dans le (ou les) réseau(x). Une connexion en parallèle évite la mise hors circuit de puces lorsqu'une ou plusieurs liaisons électriques sont interrompues, contrairement au cas d'un plan de connexion en série.

Selon une réalisation particulière, les puces peuvent comporter en outre des circuits de multiplexage pour l'adressage des premières surfaces conductrices à partir des premières bornes d'adressage.

Cette mesure est très avantageuse notamment lorsque chaque puce comporte un grand nombre de premières surfaces conductrices à adresser successivement. Elle permet en effet de réduire le nombre de bornes d'adressage.

Selon une réalisation plus simple du support, les moyens de connexion peuvent comporter des bornes, dites bornes d'adressage, disposées sur le substrat et au moins un réseau d'interconnexion reliant directement ces bornes d'adressage et les premières surfaces conductrices selon un plan de connexion prédéterminé. Les moyens de connexion peuvent comporter en outre au moins une borne reliée à la deuxième surface conductrice.

Selon un perfectionnement, le support peut comporter en outre une troisième surface conductrice apte à former une électrode de référence par rapport à la deuxième surface conductrice.

Selon une variante, le support peut comporter une troisième et une quatrième surfaces conductrices, les troisième et quatrième surfaces conductrices étant aptes à former conjointement une électrode de référence.

Les électrodes de référence sont utiles pour certains types de réactions électrochimiques, notamment celles concernant des polymères à cause des risques de dégradation chimique si le potentiel absolu appliqué sur les électrodes est trop élevé.

D'autres caractéristiques et avantages de la présente invention ressortiront mieux de la description qui va suivre, en référence aux figures des dessins annexés, donnée à titre purement illustratif et non limitatif.

### Brève description des figures

- la figure 1, déjà décrite, est une vue schématique d'une installation d'électrolyse d'un type connu,
- la figure 2, déjà décrite, est une coupe d'un support pour dépôt électrolytique d'un type connu,
- la figure 3, déjà décrite, est une vue de dessus d'un support pour dépôts électrolytiques successifs selon un procédé connu,
- les figures 4, 5 et 6 sont des vues de dessus de supports pour dépôt électrolytique conformes à l'invention,
- la figure 7 est une vue schématique d'une installation d'électrolyse utilisant un support conforme à l'invention,
- la figue 8 est une coupe schématique d'une autre installation d'électrolyse utilisant également un support conforme à l'invention.

### Description détaillée de modes de mise en oeuvre de l'invention

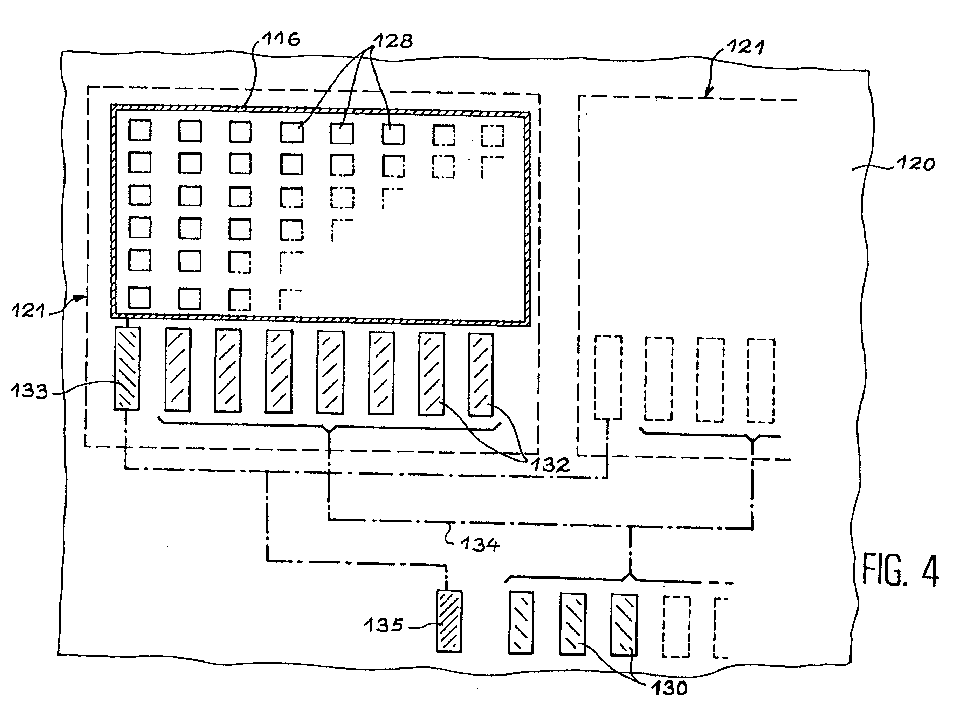

La figure 4 donne un premier exemple de réalisation d'un support conforme à l'invention.

Sur un substrat 120 actif ou passif sont réalisées une ou plusieurs puces 121 comportant chacune une pluralité de premières surfaces conductrices 128 aptes à former des électrodes.

Dans l'exemple de la figure une seule puce est représentée de façon détaillée. Une pluralité de puces identiques ou différentes formées sur le même substrat peuvent être traitées simultanément pour réaliser un dépôt électrolytique, puis être ensuite séparées pour une utilisation individuelle.

Les premières surfaces conductrices 128 qui constituent des électrodes sont adressables à partir de premières bornes d'adressage 132 disposées sur chaque puce.

Les premières surfaces conductrices 128 peuvent être reliées aux premières bornes 132 par l'intermédiaire d'un réseau de connexion non représenté.

Les premières surfaces conductrices 128 peuvent également être reliées aux premières bornes 132 par l'intermédiaire d'un circuit logique de multiplexage (non représenté). Un tel circuit permet d'adresser sélectivement un grand nombre de premières surfaces conductrices à partir d'un nombre réduit de bornes. On peut se reporter à ce sujet au document (3).

Lorsque le substrat comporte plusieurs puces devant être traitées simultanément, des deuxièmes bornes d'adressage 130 peuvent être formées sur le substrat. Toutes les premières bornes des puces sont alors reliées respectivement à des deuxièmes bornes correspondantes. La liaison entre les premières bornes 132 et les deuxièmes bornes 130 est représentée schématiquement sur la figure par un trait mixte 134. Elle est également effectuée selon un plan de connexion déterminé. Il s'agit par exemple d'un plan de connexion en parallèle, ce qui permet l'adressage des puces valides même si une puce jugée défectueuse est déconnectée.

Comme le montre la figure 4, une bande de matériau conducteur 116 est prévu sur le support. Cette bande, par exemple en Au, Ag, Pt, Ni, Al, constitue une seconde surface conductrice au sens de l'invention et forme une contre-électrode.

Dans la réalisation conforme à la figure 4, la seconde surface conductrice, c'est-à-dire la bande 116 entoure toutes les électrodes 128 de la puce. Chaque puce peut être ainsi équipée d'une seconde surface conductrice, formant contre-électrode, qui lui est propre.

Toutes les secondes surfaces conductrices formant contre-électrode sont alors reliées respectivement à une première borne 133 de la puce correspondante et les premières bornes 133 sont mutuellement reliées à une unique borne collective 135. La borne 135 permet d'appliquer à toutes les deuxièmes surfaces un potentiel de contre-électrode.

On peut noter que la bande de matériau conducteur 116 qui constitue la seconde surface conductrice peut aussi être en commun pour toutes les puces et entourer l'ensemble des premières surfaces conductrices du support. Auquel cas, elle est reliée directement à la seconde borne 135.

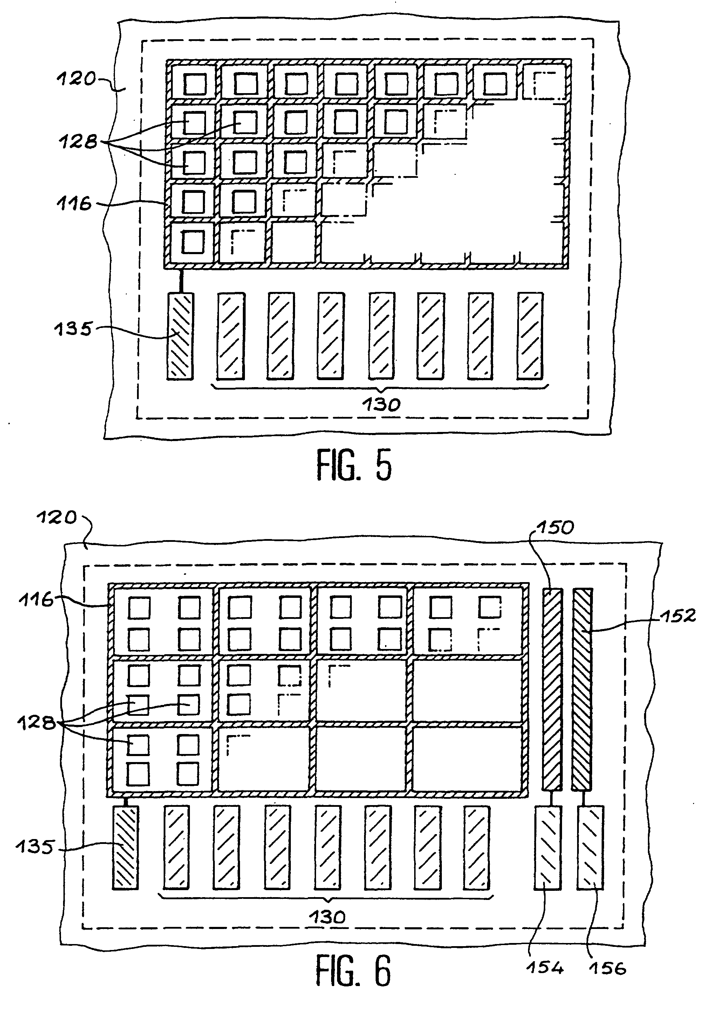

La figure 5 montre une variante de réalisation du support de l'invention.

Dans le cas des figures 5 et 6, on a représenté, pour simplifier, uniquement un ensemble de premières surfaces conductrices 128 reliées à des bornes de connexion 130 par un réseau de connexions non représenté, enterré. Il est bien entendu que les surfaces conductrices peuvent appartenir à une puce ou plusieurs puces et que des bornes d'adressage intermédiaires du type de celles référencées 132, 133, peuvent aussi être utilisées.

Dans la figure 5, une deuxième surface conductrice 116 formant contre-électrode, formée sur le substrat 120, est réalisée sous la forme d'une grille en un matériau conducteur électrique. La grille comporte une pluralité de mailles qui entourent chacune de façon individuelle, dans cet exemple, l'une des premières surfaces conductrices 128.

La grille est reliée à une borne 135 disposée en bordure du substrat 120, pour l'application d'un potentiel de contre-électrode.

La figure 6 montre une autre variante de réalisation du support de l'invention.

On y trouve, comme sur la figure 5, un substrat 120, des premières surfaces conductrices 128, formant électrodes, des bornes d'adressage 130 des premières surfaces conductrices 128, et une borne 135 pour l'application d'un potentiel sur la contre-électrode.

La contre-électrode est formée par une seconde surface conductrice 116, sous la forme d'une grille également.

Les mailles de la grille sont plus larges que celles du support de la figure 5. Chaque maille de la grille entoure un groupe de quatre premières surfaces conductrices.

Le choix de la structure de la contre-électrode est lié d'une part au type d'électrolyte employé (homogénéité du dépôt liée à la résistivité du bain et à la distance électrode/contre électrode) et d'autre part à la surface du substrat utilisable pour réaliser une contre-électrode.

Par ailleurs, une troisième et une quatrième surfaces conductrices, référencées 150 et 152, sont formés sur le substrat 120 à côté des première et deuxième surfaces conductrices.

Les troisième et quatrième surfaces 150 et 152, reliées à des bornes de mesure 154, 156, sont réalisés en des métaux (différents) ayant un potentiel oxydoréducteur connu. Il s'agit par exemple d'une bande de platine ou d'or et d'une bande d'argent.

Lorsque le support est trempé dans le bain d'électrolyte, une mesure d'un potentiel de référence peut être effectué sur les bornes 154, 156 par fermeture du circuit électrochimique comprenant les troisième et quatrième surfaces conductrices.

La mesure effectuée entre les bornes 154 et 156 permet de fixer en absolu le potentiel qui sera appliqué aux électrodes 128 et 116.

Dans une réalisation simplifiée une seule bande de métal de référence peut être suffisante. Un potentiel de référence est alors mesuré entre cette bande de métal et la bande ou grille de matériau conducteur formant la contre-électrode.

La bande de métal de référence et la contre-électrode doivent alors être réalisées en un matériau différent.

Pour l'ensemble des figures 4 à 6, on peut noter que les surfaces conductrices formant électrodes et la (ou les) surface(s) formant contre-électrode(s) sont formées sur la même face du substrat.

Un dépôt électrolytique peut être effectué sur les premières surfaces conductrices en plongeant le support dans un bain d'électrolyte et en appliquant entre la borne 135 reliée à la contre-électrode et au moins l'une des bornes 130 une tension de polarisation convenable.

Le dépôt peut être effectué sélectivement sur certaines premières surfaces en appliquant une tension et éventuellement un signal d'adressage sélectivement sur des bornes 130 correspondantes. Le signal d'adressage et les tensions à appliquer sélectivement sur les bornes peuvent être fournies par une interface d'un micro-ordinateur branché entre le générateur 118 de tension et le support.

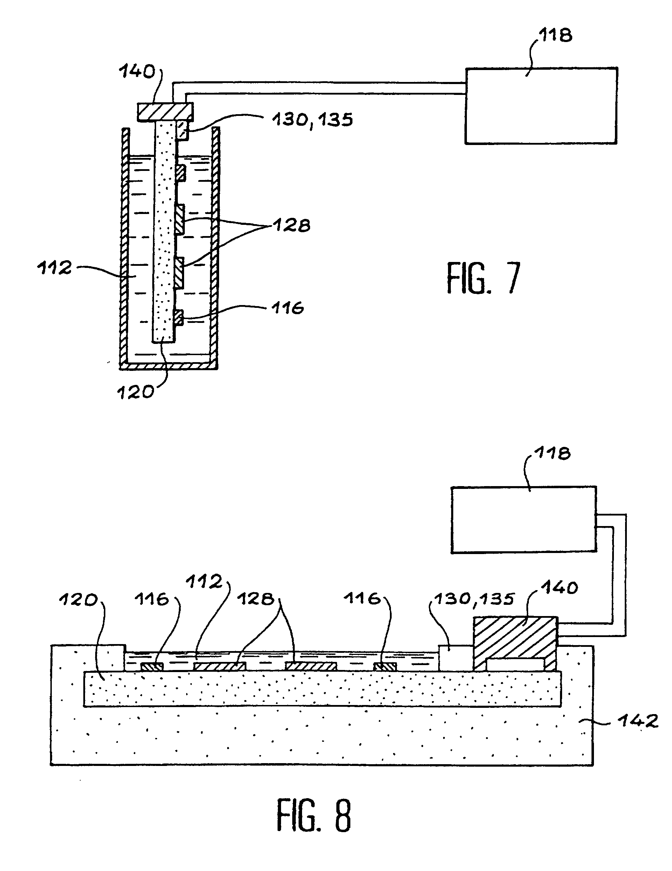

La figure 7 montre une installation d'électrolyse équipée d'un support tel que décrit ci-dessus.

Des références identiques désignent des éléments identiques ou similaires à ceux des figures précédentes.

Ainsi, un support équipé de premières surfaces 128 formant électrodes et d'une deuxième surface conductrice 116 formant contre-électrode est trempé dans une cuve 110 contenant un électrolyte 112. Les bornes de connexion (deuxièmes bornes) 130 et 135 situées sur une portion émergée du support sont reliées à un connecteur 140. Le connecteur permet de relier les bornes à un générateur de tension 118.

Comme les électrodes et la contre-électrode sont disposées sur un même substrat, un volume de bain d'électrolyte réduit, correspondant à la taille du support est suffisant.

La figure 8 montre une autre installation d'électrolyse avec un support conforme à l'invention.

Le support équipé de premières surfaces conductrices 128 et d'une deuxième surface conductrice 116, est monté dans un bac porte-échantillon 142 adapté à sa taille.

La face du support comportant les surfaces conductrices est tournée vers le haut et les bornes 130, 135 sont reliées à un générateur de tension 118 par l'intermédiaire d'un connecteur 140.

Un très fin film d'électrolyte est appliqué sur la face du support tournée vers le haut de façon à humecter les surfaces conductrices formant électrode et contre-électrode.

Il apparaît ainsi qu'une quantité très réduite d'électrolyte et seulement nécessaire pour constituer le "bain d'électrolyte".

Le coût en électrolyte pour réaliser le dépôt peut en conséquence être également réduit. Ceci est particulièrement appréciable lorsque des dépôts différents sont réalisés sur les différentes premières surfaces, et qu'une pluralité de bains électrolytes différents sont nécessaires.

### DOCUMENTS CITES DANS LA PRESENTE DEMANDE

(1) WO-94 22889 (CIS BIO INTERNATIONAL) 13. 10. 94
(2) A MONOLITHIC SENSOR ARRAY OF INDIVIDUALLY ADDRESSABLE MICROELECTRODES de R. Kakerow et al. Sensors and Actuators A, 43 (1994), pages 296-301.
(3) JP-052 67306 Patent Abstracts of Japan
(4) DE 41 31 731-A-(DR RAYMOND GLOCKER GMBH INSTITUT FÜR MEDIZINTECHNIK)
(5) GB-A-1 127 070 (ITT INDUSTRIES)
(6) PATENT ABSTRACTS OF JAPAN, vol. 15, N° 442 (E-1131), 11 Novembre 1991 & JP-03 185897-A-(MATSUSHITA ELECTRIC IND CO), 13 Août 1991.

## Revendications

1. Procédé de formation d'un dépôt électrochimique sur une pluralité d'électrodes (128) ménagées sur un support (120), **caractérisé en ce que** l'on utilise comme contre-électrode (116) une électrode intégrée sur ledit support (120).

2. Procédé selon la revendication 1, dans lequel on utilise une contre-électrode (116) sous la forme d'une bande de matériau conducteur entourant au moins une partie de la pluralité des électrodes (128).

3. Procédé selon la revendication 1, dans lequel on utilise une contre-électrode (116) sous la forme de bandes de matériau conducteur, reliées entre elles, et disposées entre les électrodes (128).

4. Procédé selon la revendication 1, dans lequel on utilise une contre-électrode (116) sous la forme d'une grille de matériau conducteur, la grille présentant une pluralité de mailles et chaque maille entourant au moins une desdites électrodes (128).

5. Procédé selon la revendication 1, dans lequel on utilise en outre une troisième électrode (150) pour mesurer un potentiel électrochimique par rapport à la contre-électrode (116).

6. Procédé selon la revendication 1, dans lequel on utilise en outre une troisième (150) et une quatrième électrodes (152) pour mesurer un potentiel électrochimique.

## Claims

1. Process for the formation of an electrochemical deposit on a plurality of electrodes (128) on a support (120), **characterized in that** the counterelectrode (116) used, is an electrode integrated on said support (120).

2. Process according to claim 1, wherein use is made of a counterelectrode (116) in the form of a conductive material strip surrounding at least part of the plurality of electrodes (128).

3. Process according to claim 1, wherein use is made of a counterelectrode (116) in the form of interconnected, conductive material strips and placed between the electrodes (128).

4. Process according to claim 1, wherein use is made of a counterelectrode (116) in the form of a conductive material grid, which has a plurality of meshes and each mesh surrounds at least one of said electrodes (128).

5. Process according to claim 1, wherein use is also made of a third electrode (150) for measuring an electrochemical potential relative to the counterelectrode (116).

6. Process according to claim 1, wherein use is also made of a third (150) and a fourth (152) electrodes for measuring an electrochemical potential.

## Patentansprüche

1. Verfahren zur Bildung einer elektrochemischen Abscheidung auf einer Vielzahl von Elektroden (128), vorgesehen auf einem Träger (120),
**dadurch gekennzeichnet, dass** man als Gegenelektrode (116) eine in den genannten Träger (120) integrierte Elektrode benutzt.

2. Verfahren nach Anspruch 1, bei dem man eine Gegenelektrode (116) in Form eines Streifens aus leitendem Material benutzt, der wenigstens einen Teil der Vielzahl von Elektroden (128) umgibt.

3. Verfahren nach Anspruch 1, bei dem man eine Gegenelektrode (116) in Form von Streifen aus einem leitenden Material benutzt, die miteinander verbunden und zwischen den Elektroden (128) angeordnet sind.

4. Verfahren nach Anspruch 1, bei dem man eine Gegenelektrode (116) in Form eines Gitters aus einem leitenden Material benutzt, wobei das Gitter eine Vielzahl von Maschen aufweist und jede Masche wenigstens eine der genannten Elektroden (128) umgibt.

5. Verfahren nach Anspruch 1, bei dem man außerdem eine dritte Elektrode (150) benutzt, um in Bezug auf die Gegenelektrode (116) ein elektrochemisches Potential zu messen.

6. Verfahren nach Anspruch 1, bei dem man außerdem eine dritte (150) und eine vierte Elektrode (152) benutzt, um ein elektrochemisches Potential zu messen.
